# EUROPEAN PATENT APPLICATION

(11) **EP 3 817 062 A2**
(43) Date of publication of application: **05.05.2021**
(21) Application number: 20203770.1
(22) Date of filing: 26.10.2020
(51) Int. Cl.: H01L 27/32

(54) **ORGANIC LIGHT-EMITTING DISPLAY APPARATUS**

(30) Priority: 29.10.2019 KR 20190135756
(71) Applicant: Samsung Display Co., Ltd., Yongin-si Gyeonggi-do 17113 (KR)
(72) Inventor: Kwon, Wonju, 17113 Gyeonggi-do (KR); Sung, Hyangki, 17113 Gyeonggi-do (KR); Jeong, Heeseong, 17113 Gyeonggi-do (KR); Hong, Sangmin, 17113 Gyeonggi-do (KR)
(74) Representative: Dr. Weitzel & Partner

(57) **Abstract**

An organic light-emitting display apparatus includes a red pixel, a green pixel, and a blue pixel, each including: a first insulating layer on a substrate; a connection electrode on the first insulating layer; a second insulating layer on the first insulating layer; an organic light-emitting diode on the second insulating layer, the organic light-emitting diode including a pixel electrode, an intermediate layer including an organic emission layer, and an opposite electrode; a pixel defining layer covering an edge of the pixel electrode and including an opening exposing the pixel electrode, the opening defining an emission area; and a via hole defined in the second insulating layer and through which the pixel electrode is connected to the connection electrode, and a spacing distance between the emission area and the via hole is different in each of the red pixel, the green pixel, and the blue pixel.

## Description

### BACKGROUND

### 1. Field

Aspects of one or more embodiments relate to an organic light-emitting display apparatus.

### 2. Description of Related Art

An organic light-emitting display apparatus includes two electrodes and an organic emission layer arranged therebetween. Electrons injected from one electrode, that is, a cathode, and holes injected from the other electrode, that is, an anode, recombine in the organic emission layer to produce excitons. The excitons emit light while releasing energy.

The organic light-emitting display apparatus includes a plurality of pixels. The pixels each include an organic light-emitting diode (OLED) including a cathode, an anode, and an organic emission layer. The pixels each include a capacitor and a plurality of transistors configured to drive the OLED. The transistors each basically include a switching transistor and a driving transistor. The organic light-emitting display apparatus has a short response time and is driven with low power consumption.

As the resolution is increased, a plurality of insulating layers are used such that an OLED, a plurality of transistors configured to drive the OLED, a capacitor, and wirings configured to transfer signals thereto are arranged to overlap each other. Accordingly, various issues may occur.

### SUMMARY

According to an aspect of one or more embodiments, an organic light-emitting display apparatus is capable of reducing a side color shift phenomenon and ensuring excellent visibility while minimizing or reducing a difference in characteristics between pixels.

Additional aspects will be set forth, in part, in the description which follows and, in part, will be apparent from the description, or may be learned by practice of the presented embodiments of the disclosure.

According to one or more embodiments, an organic light-emitting display apparatus includes a red pixel, a green pixel, and a blue pixel, each including: a first insulating layer on a substrate; a connection electrode on the first insulating layer; a second insulating layer on the first insulating layer to cover the connection electrode; an organic light-emitting diode on the second insulating layer, the organic light-emitting diode including a pixel electrode, an intermediate layer including an organic emission layer, and an opposite electrode; a pixel defining layer covering an edge of the pixel electrode and including an opening exposing a central portion of the pixel electrode, the opening defining an emission area; and a via hole defined in the second insulating layer and through which the pixel electrode is connected to the connection electrode, wherein a spacing distance between the emission area and the via hole is different in each of the red pixel, the green pixel, and the blue pixel.

In the red pixel, 0 ≤ d(R) ≤ 1.2 µm or d(R) ≥ 5 µm may be satisfied, where d(R) is the spacing distance between the emission area and the via hole in the red pixel, and in the blue pixel, 0 ≤ d(B) ≤ 1.2 µm or d(B) ≥ 5 µm may be satisfied, where d(B) is the spacing distance between the emission area and the via hole in the blue pixel.

In the green pixel, 0 ≤ d(G) ≤ 2.8 µm or d(G) ≥ 5 µm may be satisfied, where d(G) is the spacing distance between the emission area and the via hole in the green pixel.

In at least one of the red pixel, the green pixel, and the blue pixel, an upper surface of the second insulating layer in the emission area has a first slope portion and a second slope portion which are sloped in different directions from each other.

In at least one of the red pixel, the green pixel, and the blue pixel, an upper surface of the second insulating layer in the emission area may be parallel to an upper surface of the substrate.

The organic light-emitting display apparatus may further include a first wiring on a same layer as the connection electrode and located adjacent to the emission area of the green pixel, and a spacing distance between the emission area of the green pixel and the first wiring may be greater than or equal to 1.2 µm.

The organic light-emitting display apparatus may further include a first wiring and a second wiring, which are on a same layer as the connection electrode with the emission area therebetween, and a spacing distance between the first wiring and the emission area may be equal to a spacing distance between the second wiring and the emission area.

The spacing distance between the first wiring and the emission area may be less than or equal to 1.2 µm.

The organic light-emitting display apparatus may further include a first wiring and a second wiring, which are on a same layer as the connection electrode with the emission area therebetween, and a spacing distance between the first wiring and the emission area may be different from a spacing distance between the second wiring and the emission area, and the spacing distance between the first wiring and the emission area may be greater than the spacing distance between the second wiring and the emission area by 1.2 µm or more.

The red pixel, the green pixel, and the blue pixel may be arranged in a pentile matrix structure, and an emission area of the green pixel may be smaller than emission areas of the red pixel and the blue pixel.

According to one or more embodiments, an organic light-emitting display apparatus includes: a first insulating layer on a substrate; a connection electrode on the first insulating layer; a second insulating layer on the first insulating layer to cover the connection electrode; an organic light-emitting diode on the second insulating layer, the organic light-emitting diode including a pixel electrode, an intermediate layer including an organic emission layer, and an opposite electrode; a pixel defining layer covering an edge of the pixel electrode and including an opening exposing a central portion of the pixel electrode, the opening defining an emission area; and a via hole defined in the second insulating layer and through which the pixel electrode is connected to the connection electrode, wherein an upper surface of the second insulating layer includes a flat portion parallel to an upper surface of the substrate, a first slope portion having a first slope angle with respect to the upper surface of the substrate, and a second slope portion having a second slope angle with respect to the upper surface of the substrate, the second slope angle greater than the first slope angle, and the second slope portion is located closer to the via hole than the first slope portion.

The emission area may overlap with the first slope portion and the second slope portion.

An area in which the first slope portion overlaps with the emission area may be larger than an area in which the second slope portion overlaps with the emission area.

The emission area may overlap with the flat portion and not overlap with the second slope portion.

The organic light-emitting display apparatus may further include a first wiring and a second wiring, which are on a same layer as the connection electrode with the emission area therebetween, and a spacing distance between the first wiring and the emission area may be equal to a spacing distance between the second wiring and the emission area.

The spacing distance between first wiring and the emission area may be less than or equal to 1.2 µm.

The first insulating layer may be bent according to shapes of the first wiring and the second wiring.

The organic light-emitting display apparatus may further include a first wiring and a second wiring, which are on a same layer as the connection electrode with the emission area therebetween, and a spacing distance between the first wiring and the emission area may be different from a spacing distance between the second wiring and the emission area, and the spacing distance between the first wiring and the emission area may be greater than the spacing distance between the second wiring and the emission area by 1.2 µm or more.

The organic light-emitting display apparatus may further include a red pixel, a green pixel, and a blue pixel, and a spacing distance between the emission area and the via hole may be different in each of the red pixel, the green pixel, and the blue pixel.

The red pixel, the green pixel, and the blue pixel may be arranged in a pentile matrix structure, and an emission area of the green pixel may be smaller than emission areas of the red pixel and the blue pixel.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic plan view of an organic light-emitting display apparatus according to an embodiment;
FIGS. 2A and 2B are equivalent circuit diagrams of a pixel in an organic light-emitting display apparatus, according to some embodiments;
FIG. 3 is a schematic layout diagram illustrating emission areas of a plurality of pixels in an organic light-emitting display apparatus, according to an embodiment;
FIG. 4A is a schematic layout diagram illustrating a relationship between an emission area, a pixel electrode, and a via hole arranged at a side of the pixel electrode in a pixel, according to an embodiment;
FIG. 4B is a schematic cross-sectional view taken along the line I-I' of FIG. 4A;
FIG. 5A is a schematic layout diagram illustrating a relationship between an emission area, a pixel electrode, and a via hole arranged at a side of the pixel electrode in a pixel, according to another embodiment;
FIG. 5B is a schematic cross-sectional view taken along the line II-II' of FIG. 5A;
FIG. 6A is a schematic layout diagram illustrating a relationship between an emission area, a pixel electrode, and a wiring arranged below the pixel electrode in a pixel, according to another embodiment;
FIG. 6B is a schematic cross-sectional view taken along the line III-III' of FIG. 6A;
FIG. 7A is a schematic layout diagram illustrating a relationship between an emission area, a pixel electrode, and a wiring arranged below the pixel electrode in a pixel, according to another embodiment;
FIG. 7B is a schematic cross-sectional view taken along the line IV-IV' of FIG. 7A; and
FIG. 8 is a schematic layout diagram illustrating a relationship between emission areas, pixel electrodes, and wirings arranged below the pixel electrodes in a plurality of pixels, according to an embodiment.

### DETAILED DESCRIPTION

Reference will now be made in further detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, some embodiments are merely described below, by referring to the figures, to explain aspects of the present description. As used herein, the term "and/or" includes any and all combinations of one or more of the associated listed items. Throughout the disclosure, the expression "at least one of a, b, or c" indicates only a, only b, only c, both a and b, both a and c, both b and c, all of a, b, and c, or variations thereof.

It is to be understood that although the terms "first," "second," etc. may be used herein to describe various elements, these elements should not be limited by these terms. These terms are used to distinguish one element from another.

As used herein, the singular forms "a," "an," and "the" are intended to include the plural forms as well, unless the context clearly indicates otherwise.

It is to be understood that terms such as "comprise," "include," and "have" used herein specify the presence of stated features or elements, but do not preclude the presence or addition of one or more other features or elements.

It is to be understood that when a layer, region, or element is referred to as being "on" another layer, region, or element, it may be directly on the other layer, region, or element or may be indirectly on the other layer, region, or element with one or more intervening layers, regions, or elements therebetween.

Sizes of components in the drawings may be exaggerated for convenience of description. In other words, since the sizes and thicknesses of elements in the drawings may be arbitrarily illustrated for convenience of description, the following embodiments are not limited thereto.

In the following embodiments, it is to be understood that when a film, layer, region, element, or component is referred to as being "connected to" or "coupled to" another film, layer, region, element, or component, it may be directly or indirectly connected or coupled to the other film, layer, region, element, or component. That is, for example, one or more intervening films, layers, regions, elements, or components may be present.

In the following embodiments, the x-axis, the y-axis, and the z-axis are not limited to three axes of the rectangular coordinate system, and may be interpreted in a broader sense. For example, the x-axis, the y-axis, and the z-axis may be perpendicular to one another, or may represent different directions that are not perpendicular to one another.

Unless otherwise defined, all terms (including technical and scientific terms) used herein have the same meaning as commonly understood by one of ordinary skill in the art to which example embodiments of the inventive concept belong. It is to be further understood that terms, such as those defined in commonly-used dictionaries, should be interpreted as having a meaning that is consistent with their meaning in the context of the relevant art and will not be interpreted in an idealized or overly formal sense unless expressly so defined herein.

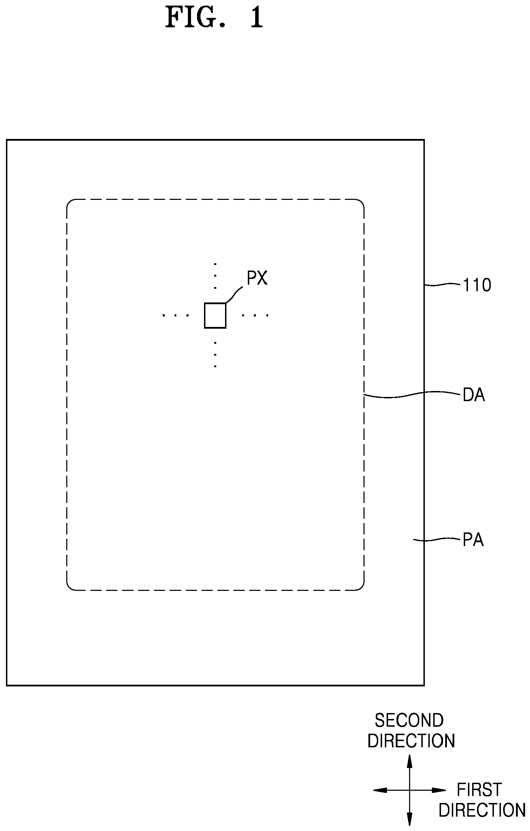

FIG. 1 is a schematic plan view of an organic light-emitting display apparatus according to an embodiment.

Referring to FIG. 1, the organic light-emitting display apparatus may include a display area DA and a peripheral area PA that is a non-display area. A plurality of pixels PX each including a display element may be arranged in the display area DA to provide a certain image.

The pixels PX may each emit light of, for example, a red, green, blue, or white color and may include, for example, an organic light-emitting diode. In addition, the pixels PX may each further include a device such as a thin-film transistor (TFT) and a capacitor.

The term "pixel PX" as used herein refers to a subpixel that emits light of any one of red, green, blue, and white colors as described above.

The peripheral area PA may be an area in which no image is provided. The peripheral area PA may include a scan driver, a data driver, and the like, which provide electrical signals to be applied to the pixels PX of the display area DA, and power lines configured to supply power, such as a driving voltage and a common voltage.

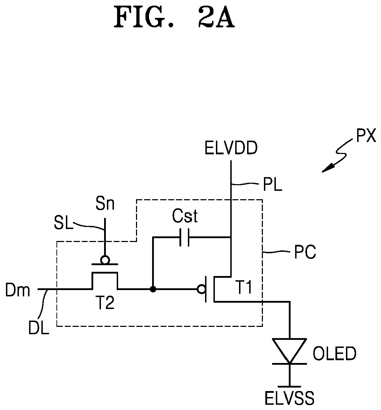

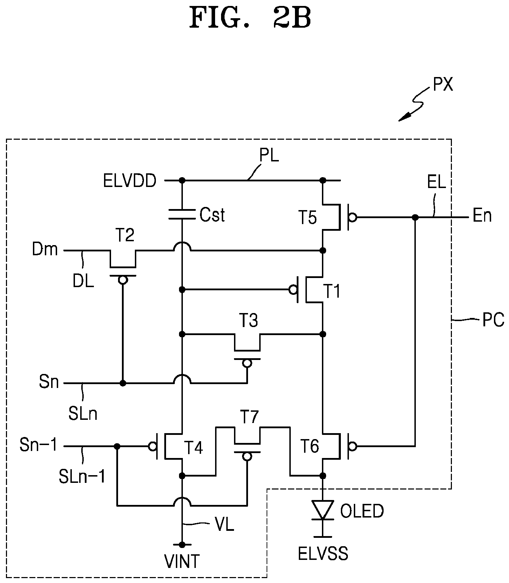

FIGS. 2A and 2B are equivalent circuit diagrams of a pixel in an organic light-emitting display apparatus, according to some embodiments.

Referring to FIG. 2A, the pixels PX may each include a pixel circuit PC connected to a scan line SL and a data line DL, and an organic light-emitting diode OLED connected to the pixel circuit PC.

The pixel circuit PC may include a driving thin-film transistor T1, a switching thin-film transistor T2, and a storage capacitor Cst. The switching thin-film transistor T2 may be connected to the scan line SL and the data line DL and may be configured to transfer, to the driving thin-film transistor T1, a data signal Dm input through the data line DL according to a scan signal Sn input through the scan line SL.

The storage capacitor Cst may be connected to the switching thin-film transistor T2 and a driving voltage line PL and may be configured to store a voltage corresponding to a difference between a voltage received from the switching thin-film transistor T2 and a first power supply voltage ELVDD (or a driving voltage) supplied to the driving voltage line PL.

The driving thin-film transistor T1 may be connected to the driving voltage line PL and the storage capacitor Cst and may be configured to control a driving current flowing from the driving voltage line PL to the organic light-emitting diode OLED according to a voltage value stored in the storage capacitor Cst. The organic light-emitting diode OLED may emit light having a certain luminance according to the driving current.

A case in which the pixel circuit PC includes two thin-film transistors and one storage capacitor has been described with reference to FIG. 2A, but embodiments are not limited thereto.

Referring to FIG. 2B, according to an embodiment, a pixel circuit PC may include a driving thin-film transistor T1, a switching thin-film transistor T2, a compensation thin-film transistor T3, a first initialization thin-film transistor T4, an operation control thin-film transistor T5, an emission control thin-film transistor T6, and a second initialization thin-film transistor T7.

FIG. 2B illustrates a case in which signal lines SLn, SLn-1, EL, and DL, an initialization voltage line VL, and a driving voltage line PL are provided for each pixel PX, but embodiments are not limited thereto. In another embodiment, at least one of the signal lines SLn, SLn-1, EL, and DL, and/or the initialization voltage line VL may be shared with the adjacent pixels.

A drain electrode of the driving thin-film transistor T1 may be electrically connected to an organic light-emitting diode OLED through the emission control thin-film transistor T6. The driving thin-film transistor T1 may be configured to receive a data signal Dm and supply a driving current to the organic light-emitting diode OLED according to a switching operation of the switching thin-film transistor T2.

A gate electrode of the switching thin-film transistor T2 may be connected to the scan line SLn, and a source electrode of the switching thin-film transistor T2 may be connected to the data line DL. A drain electrode of the switching thin-film transistor T2 may be connected to a source electrode of the driving thin-film transistor T1 and connected to the driving voltage line PL through the operation control thin-film transistor T5.

The switching thin-film transistor T2 may be turned on according to a scan signal Sn received through the scan line SLn to perform a switching operation to transfer the data signal Dm received through the data line DL to the source electrode of the driving thin-film transistor T1.

A gate electrode of the compensation thin-film transistor T3 may be connected to the scan line SLn. A source electrode of the compensation thin-film transistor T3 may be connected to the drain electrode of the driving thin-film transistor T1 and connected to a pixel electrode of the organic light-emitting diode OLED through the emission control thin-film transistor T6. A drain electrode of the compensation thin-film transistor T3 may be connected to any one electrode of the storage capacitor Cst, a source electrode of the first initialization thin-film transistor T4, and a gate electrode of the driving thin-film transistor T1. The compensation thin-film transistor T3 may be turned on according to the scan signal Sn received through the scan line SLn to connect the gate electrode and the drain electrode of the driving thin-film transistor T1 to each other such that the driving thin-film transistor T1 is diode-connected.

A gate electrode of the first initialization thin-film transistor T4 may be connected to a previous scan line SLn-1. A drain electrode of the first initialization thin-film transistor T4 may be connected to the initialization voltage line VL. The source electrode of the first initialization thin-film transistor T4 may be connected to any one electrode of the storage capacitor Cst, the drain electrode of the compensation thin-film transistor T3, and the gate electrode of the driving thin-film transistor T1. The first initialization thin-film transistor T4 may be turned on according to a previous scan signal Sn-1 received through the previous scan line SLn-1 to perform an initialization operation to transfer an initialization voltage VINT to the gate electrode of the driving thin-film transistor T1 so as to initialize the voltage of the gate electrode of the driving thin-film transistor T1.

A gate electrode of the operation control thin-film transistor T5 may be connected to an emission control line EL. A source electrode of the operation control thin-film transistor T5 may be connected to the driving voltage line PL. A drain electrode of the operation control thin-film transistor T5 may be connected to the source electrode of the driving thin-film transistor T1 and the drain electrode of the switching thin-film transistor T2.

A gate electrode of the emission control thin-film transistor T6 may be connected to the emission control line EL. A source electrode of the emission control thin-film transistor T6 may be connected to the drain electrode of the driving thin-film transistor T1 and the source electrode of the compensation thin-film transistor T3. A drain electrode of the emission control thin-film transistor T6 may be electrically connected to the pixel electrode of the organic light-emitting diode OLED. The operation control thin-film transistor T5 and the emission control thin-film transistor T6 may be concurrently (e.g., simultaneously) turned on according to an emission control signal En received through the emission control line EL to transfer a first power supply voltage ELVDD to the organic light-emitting diode OLED such that the driving current flows through the organic light-emitting diode OLED.

A gate electrode of the second initialization thin-film transistor T7 may be connected to the previous scan line SLn-1. A source electrode of the second initialization thin-film transistor T7 may be connected to the pixel electrode of the organic light-emitting diode OLED. A drain electrode of the second initialization thin-film transistor T7 may be connected to the initialization voltage line VL. The second initialization thin-film transistor T7 may be turned on according to the previous scan signal Sn-1 received through the previous scan line SLn-1 to initialize the pixel electrode of the organic light-emitting diode OLED.

FIG. 2B illustrates a case in which the first initialization thin-film transistor T4 and the second initialization thin-film transistor T7 are connected to the previous scan line SLn-1, but embodiments are not limited thereto. In another embodiment, the first initialization thin-film transistor T4 may be connected to the previous scan line SLn-1 and may be driven according to the previous scan signal Sn-1, and the second initialization thin-film transistor T7 may be connected to a separate signal line (for example, a next scan line) and may be driven according to a signal received through the corresponding scan line.

The other electrode of the storage capacitor Cst may be connected to the driving voltage line PL. Any one electrode of the storage capacitor Cst may be connected to the gate electrode of the driving thin-film transistor T1, the drain electrode of the compensation thin-film transistor T3, and the source electrode of the first initialization thin-film transistor T4.

An opposite electrode (for example, a cathode) of the organic light-emitting diode OLED may receive a second power supply voltage ELVSS (or a common power supply voltage). The organic light-emitting diode OLED may receive the driving current from the driving thin-film transistor T1 and emit light.

However, the pixel circuit PC is not limited to the number and the circuit design of the thin-film transistors and the storage capacitors described above with reference to FIGS. 2A and 2B, and the number and the circuit design of the thin-film transistors and the storage capacitors may be variously changed.

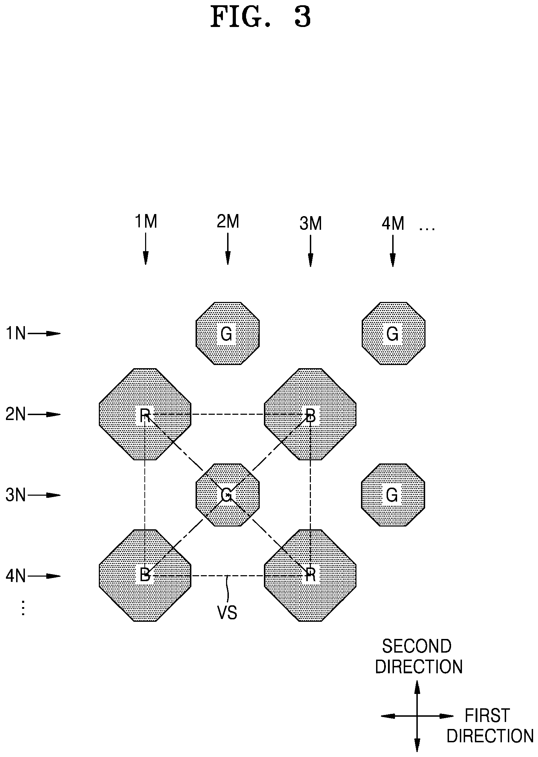

FIG. 3 is a schematic layout diagram illustrating emission areas of a plurality of pixels R, G, and B in an organic light-emitting display apparatus, according to an embodiment. In this case, the emission area of the pixel may be defined by an opening of a pixel defining layer, which will be described below.

As illustrated in FIG. 3, in an embodiment, a plurality of green pixels G may be apart from each other in a first row 1N at certain intervals. A plurality of red pixels R and a plurality of blue pixels B may be alternately arranged in an adjacent second row 2N. A plurality of green pixels G may be apart from each other in an adjacent third row 3N at certain intervals. A plurality of blue pixels B and a plurality of red pixels R may be alternately arranged in an adjacent fourth row 4N. Such pixel arrangement may be repeated up to an N^{th} row. In an embodiment, the blue pixel B and the red pixel R may be larger than the green pixel G.

In an embodiment, the green pixels G arranged in the first row 1N and the red pixels R and the blue pixels B arranged in the second row 2N may be alternately arranged. Therefore, the red pixels R and the blue pixels B may be alternately arranged in a first column 1M. The green pixels G may be apart from each other in an adjacent second column 2M at certain intervals. The blue pixels B and the red pixels R may be alternately arranged in an adjacent third column 3M. The green pixels G may be apart from each other in an adjacent fourth column 4M at certain intervals. Such pixel arrangement may be repeated up to an M^{th} column.

The pixel arrangement structure may be expressed differently as follows: the red pixels R are arranged at first and third vertices facing each other among the vertices of a virtual rectangle VS having a center point of the green pixel G as a center point of a rectangle, and the blue pixels B are arranged at the remaining vertices, that is, second and fourth vertices. In this case, the virtual rectangle VS may be modified in various forms, such as a rectangle, a rhombus, and a square.

However, the pixel arrangement structure is not limited thereto. For example, in FIG. 3, the blue pixel B instead of the green pixel G may be arranged at the center point of the virtual rectangle VS, the red pixels R may be arranged at the first and third vertices facing each other among the vertices of the virtual rectangle VS, and the green pixels G may be arranged at the remaining vertices, that is, the second and fourth vertices.

Such a pixel arrangement structure is referred to as a pentile matrix, and high resolution may be implemented with a small number of pixels by applying a rendering driving that expresses colors by sharing adjacent pixels.

However, the pixel arrangement structure according to one or more embodiments is not limited to the pentile matrix structure. For example, one or more embodiments may be applied to a pixel arrangement structure having a stripe arrangement, a mosaic arrangement, or a delta arrangement. One or more embodiments may also be applied to a pixel arrangement structure further including a white pixel that emits white light.

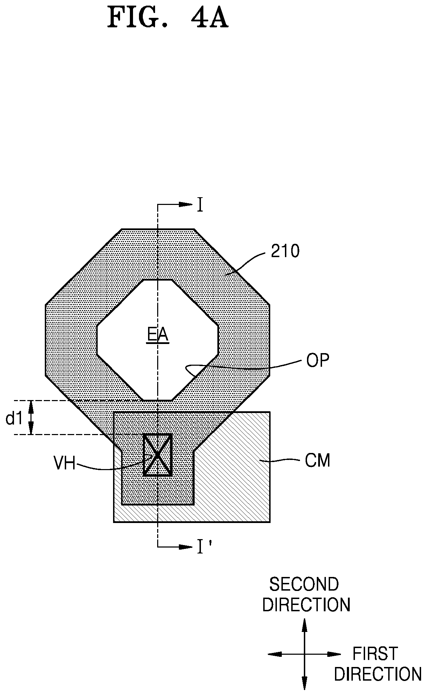

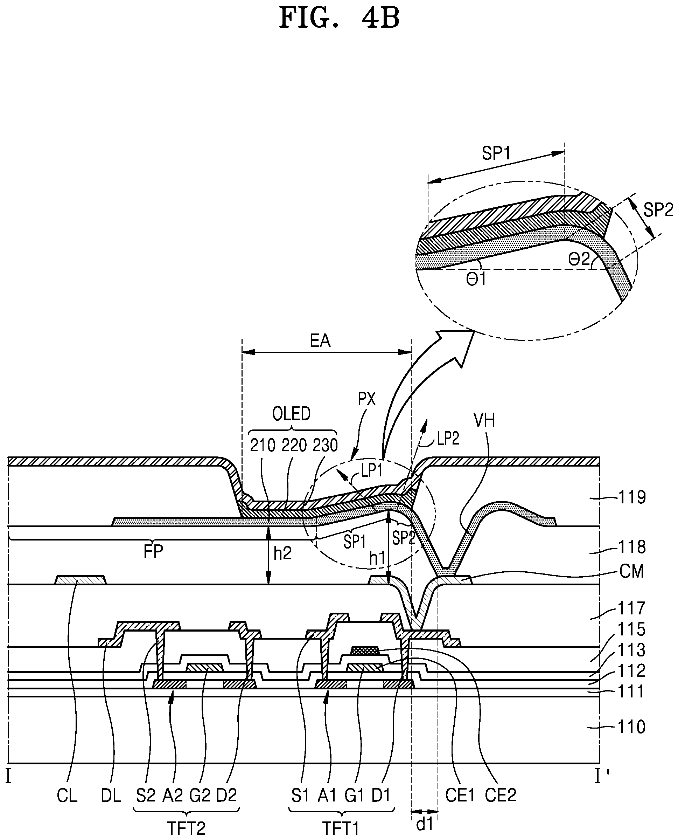

FIG. 4A is a schematic layout diagram illustrating a relationship between an emission area EA, a pixel electrode 210, and a via hole VH arranged at a side of the pixel electrode 210 in a pixel PX, according to an embodiment; and FIG. 4B is a schematic cross-sectional view taken along the line I-I' of FIG. 4A.

Referring to FIGS. 4A and 4B, the pixel electrode 210 included in the pixel PX may include the emission area EA, through which light is emitted, and an area overlapping the via hole VH. The emission area EA may be defined by an opening OP of a pixel defining layer 119 that exposes a central portion of the pixel electrode 210. The via hole VH may be defined in a second insulating layer 118 so as to connect the pixel electrode 210 to a connection electrode CM. When the pixel electrode 210 is inserted into the via hole VH, the pixel electrode 210 may be connected to the connection electrode CM.

In this case, the pixels PX according to the present embodiment may be designed such that a spacing distance (d) between the opening OP and the via hole VH satisfies a certain range. The spacing distance (d) may be a shortest distance (d) between an end of the opening OP and an end of the via hole VH. Alternatively, the spacing distance (d) may be a spacing distance between the end of the opening OP and the end of the via hole VH in a second direction.

In one embodiment, the spacing distance (d) may satisfy 0 ≤ d ≤ d1. In an embodiment, d1 may have different values according to the red pixel, the green pixel, and the blue pixel. In an embodiment, in the case of the red pixel and the blue pixel, d1(R, B) = 1.2 µm, and, in the case of the green pixel, d1(G) = 2.8 µm. These numerical values may be introduced such that a viewing angle in a vertical direction (second direction) is made uniform or substantially uniform.

Herein, a stacked structure of an organic light-emitting display apparatus according to an embodiment will be described.

The substrate 110 may include various materials, such as a glass material, a metal material, or a plastic material. In one embodiment, the substrate 110 may be a flexible substrate. For example, the substrate 110 may include a polymer resin, such as polyethersulfone (PES), polyacrylate, polyetherimide (PEI), polyethylene naphthalate (PEN), polyethylene terephthalate (PET), polyphenylene sulfide (PPS), polyarylate (PAR), polyimide (PI), polycarbonate (PC), or cellulose acetate propionate (CAP).

A buffer layer 111 may be arranged on the substrate 110. The buffer layer 111 may reduce or block penetration of foreign matters, moisture, or external air from the bottom of the substrate 110 and may provide a flat surface on the substrate 110. The buffer layer 111 may include an inorganic material such as an oxide or a nitride, an organic material, or an organic/inorganic composite, and may have a single-layered structure or a multi-layered structure of an inorganic material and an organic material. In an embodiment, a barrier layer (not illustrated) configured to block penetration of external air may be further included between the substrate 110 and the buffer layer 111.

A first thin-film transistor TFT1 may include a semiconductor layer A1, a gate electrode G1, a source electrode S1, and a drain electrode D1, and a second thin-film transistor TFT2 may include a semiconductor layer A2, a gate electrode G2, a source electrode S2, and a drain electrode D2. The first thin-film transistor TFT1 may be connected to an organic light-emitting diode OLED. The second thin-film transistor TFT2 may function as a switching thin-film transistor. Although two thin-film transistors are illustrated in FIG. 4B, embodiments are not limited thereto. The number of thin-film transistors may be variously modified. For example, two to seven thin-film transistors may be provided.

In an embodiment, the semiconductor layers A1 and A2 may each include amorphous silicon or polycrystalline silicon. In another embodiment, the semiconductor layers A1 and A2 may each include an oxide of at least one selected from indium (In), gallium (Ga), tin (Sn), zirconium (Zr), vanadium (V), hafnium (Hf), cadmium (Cd), germanium (Ge), chromium (Cr), titanium (Ti), and zinc (Zn). In an embodiment, the semiconductor layers A1 and A2 may each include a channel region, and a source region and a drain region doped with impurities.

The gate electrodes G1 and G2 may be arranged on the semiconductor layers A1 and A2, respectively, with a first gate insulating layer 112 therebetween. The gate electrodes G1 and G2 may each include molybdenum (Mo), aluminum (Al), copper (Cu), titanium (Ti), or the like, and may each be a single layer or a multi-layer. For example, the gate electrodes G1 and G2 may each be a single layer of Mo.

In an embodiment, the first gate insulating layer 112 may include silicon oxide (SiO₂), silicon nitride (SiNₓ), silicon oxynitride (SiON), aluminum oxide (Al₂O₃), titanium oxide (TiO₂), tantalum oxide (Ta₂O₅), hafnium oxide (HfO₂), or zinc oxide (ZnO₂).

A second gate insulating layer 113 may be provided to cover the gate electrodes G1 and G2. In an embodiment, the second gate insulating layer 113 may include silicon oxide (SiO₂), silicon nitride (SiNₓ), silicon oxynitride (SiON), aluminum oxide (Al₂O₃), titanium oxide (TiO₂), tantalum oxide (Ta₂O₅), hafnium oxide (HfO₂), or zinc oxide (ZnO₂).

A first electrode CE1 of the storage capacitor Cst may overlap the first thin-film transistor TFT1. For example, the gate electrode G1 of the first thin-film transistor TFT1 may function as the first electrode CE1 of the storage capacitor Cst.

A second electrode CE2 of the storage capacitor Cst may overlap the first electrode CE1 with the second gate insulating layer 113 therebetween. In this case, the second gate insulating layer 113 may function as a dielectric layer of the storage capacitor Cst. The second electrode CE2 may include a conductive material including any of molybdenum (Mo), aluminum (Al), copper (Cu), titanium (Ti), and the like, and may be a single layer or a multi-layer including the above-described material. For example, the second electrode CE2 may be a single layer of Mo or a multi-layer of Mo/AI/Mo.

An interlayer insulating layer 115 may be arranged to cover the second electrode CE2. In an embodiment, the interlayer insulating layer 115 may include silicon oxide (SiO₂), silicon nitride (SiNₓ), silicon oxynitride (SiON), aluminum oxide (Al₂O₃), titanium oxide (TiO₂), tantalum oxide (Ta₂O₅), hafnium oxide (HfO₂), or zinc oxide (ZnO₂).

The source electrodes S1 and S2 and the drain electrodes D1 and D2 may be arranged on the interlayer insulating layer 115. The source electrodes S1 and S2 and the drain electrodes D1 and D2 may each include a conductive material including any of molybdenum (Mo), aluminum (Al), copper (Cu), titanium (Ti), and the like, and may each be a single layer or a multi-layer including the above-described material. For example, the source electrodes S1 and S2 and the drain electrodes D1 and D2 may each have a multi-layered structure of Ti/Al/Ti.

A first insulating layer 117 may be arranged on the source electrodes S1 and S2 and the drain electrodes D1 and D2. A conductive layer CL and a connection electrode CM, which are usable as an electrode or a wiring, may be arranged on the first insulating layer 117.

A second insulating layer 118 may be arranged on the first insulating layer 117 so as to cover the conductive layer CL and the connection electrode CM. As such, since the first insulating layer 117 and the second insulating layer 118 are provided, the thin-film transistors and the various wirings may be arranged to overlap each other, thereby achieving high integration.

Various members may be arranged under the first insulating layer 117, and the upper surface of the first insulating layer 117 may be bent by the members. In the present embodiment, since the second insulating layer 118 is additionally provided, the influence of the bent portions on the emission area may be minimized or reduced.

The first insulating layer 117 and the second insulating layer 118 may each be a single layer or a multi-layer of a film including an organic material. In an embodiment, the first insulating layer 117 may include a general-purpose polymer (for example, benzocyclobutene (BCB), polyimide, hexamethyldisiloxane (HMDSO), polymethylmethacrylate (PMMA), or polystyrene (PS)), a polymer derivative having a phenol-based group, an acryl-based polymer, an imide-based polymer, an arylether-based polymer, an amide-based polymer, a fluorine-based polymer, a p-xylene-based polymer, a vinyl alcohol-based polymer, and any blend thereof.

The conductive layer CL arranged on the first insulating layer 117 may function as a driving voltage line configured to transfer a driving voltage or a data line configured to transfer a data signal. The conductive layer CL may be connected to members arranged on other layers through contact holes (not illustrated) defined in the first insulating layer 117. In addition, the pixel electrode 210 of the organic light-emitting diode OLED and the first thin-film transistor TFT1 may be connected to each other through the connection electrode CM arranged on the first insulating layer 117. The conductive layer CL and the connection electrode CM may each include molybdenum (Mo), aluminum (Al), copper (Cu), titanium (Ti), or the like, and may each be a single layer or a multi-layer.

The organic light-emitting diode OLED may be arranged on the second insulating layer 118. The organic light-emitting diode OLED may include the pixel electrode 210, an intermediate layer 220 including an organic emission layer, and an opposite electrode 230.

The pixel electrode 210 may be a transmissive electrode or a reflective electrode. In one or more embodiments, the pixel electrode 210 may include a reflective film and a transparent or semitransparent electrode layer arranged on the reflective film. In an embodiment, the reflective film may include Ag, Mg, Al, Pt, Pd, Au, Ni, Nd, Ir, Cr, or any compound thereof. In an embodiment, the transparent or semitransparent electrode layer may include at least one selected from indium tin oxide (ITO), indium zinc oxide (IZO), zinc oxide (ZnO), indium oxide (In₂O₃), indium gallium oxide (IGO), and aluminum zinc oxide (AZO).

A pixel defining layer 119 may be arranged on the second insulating layer 118. Since the pixel defining layer 119 has an opening OP corresponding to each subpixel, that is, an opening OP exposing the central portion of at least the pixel electrode 210, the pixel defining layer 119 may define an emission area of a pixel. In addition, the pixel defining layer 119 increases a distance between the edge of the pixel electrode 210 and the opposite electrode 230 above the pixel electrode 210, thereby preventing or substantially preventing arcs or the like from occurring at the edge of the pixel electrode 210. In an embodiment, the pixel defining layer 119 may include at least one organic insulating material selected from polyimide, polyamide, an acrylic resin, benzocyclobutene, and a phenol resin, and may be formed by spin coating or the like.

The intermediate layer 220 of the organic light-emitting diode OLED may include an organic emission layer. The organic emission layer may include an organic material including a fluorescent or phosphorescent material emitting light of a red color, a green color, a blue color, or a white color. The organic emission layer may include a low-molecular-weight organic material or a high-molecular-weight organic material. Functional layers, such as a hole transport layer (HTL), a hole injection layer (HIL), an electron transport layer (ETL), and an electron injection layer (EIL), may optionally be further arranged below and above the organic emission layer. In an embodiment, the intermediate layer 220 may be arranged corresponding to each of a plurality of pixel electrodes 210. However, embodiments are not limited thereto. The intermediate layer 220 may be variously modified. For example, the intermediate layer 220 may include an integrated layer over the pixel electrodes 210.

The opposite electrode 230 may be a transmissive electrode or a reflective electrode. In one or more embodiments, the opposite electrode 230 may be a transparent or semitransparent electrode and may include a metal thin-film that has a low work function and includes Li, Ca, LiF/Ca, LiF/Al, Al, Ag, Mg, or any compound thereof. In an embodiment, a transparent conductive oxide (TCO) film, such as ITO, IZO, ZnO, or In₂O₃, may be further arranged on the metal thin-film. In an embodiment, the opposite electrode 230 may be integrally formed in the organic light-emitting diodes OLED so as to correspond to the pixel electrodes 210.

The pixel electrode 210 may be connected to the connection electrode CM through the via hole VH defined in the second insulating layer 118. In an embodiment, the via hole VH may be formed by applying a material for forming the second insulating layer 118 and exposing, developing, and curing the material using a mask process. In an embodiment, the second insulating layer 118 may be inclined with respect to the via hole VH. That is, in some regions, an upper surface of the second insulating layer 118 may not be parallel to the upper surface of the substrate 110.

For example, as illustrated in FIG. 4B, the second insulating layer 118 may have a first thickness h1, which is a greatest thickness, around the via hole VH, and the second insulating layer 118 may have a second thickness h2, which is less than the first thickness h1, in an area farther away, or distal, from the via hole VH. In an embodiment, the upper surface of the second insulating layer 118 may be formed to have a steeper slope in a region closer to the via hole VH, and the upper surface of the second insulating layer 118 may be formed to have a gentler slope or be parallel to the upper surface of the substrate 110 in a region farther away from the via hole VH.

In an embodiment, the upper surface of the second insulating layer 118 may include a flat portion FP provided in parallel with the upper surface of the substrate 110, a first slope portion SP1 having a relatively gentle first slope angle θ1, and a second slope portion SP2 having a relatively steep second slope angle θ2. In an embodiment, the first slope portion SP1 may have a slope in a direction opposite to that of the second slope portion SP2, and the first slope angle θ1 may be less than the second slope angle θ2. The first slope portion SP1 and the second slope portion SP2 may be formed with respect to a point at which the second insulating layer 118 has the first thickness h1 that is the greatest thickness.

In the present embodiment, the value of d1 may be a value set such that both the first slope portion SP1 and the second slope portion SP2 are arranged in the emission area EA. That is, the emission area EA may be arranged to overlap the first slope portion SP1 and the second slope portion SP2.

If only the first slope portion SP1 is arranged in the emission area EA, light in the emission area EA arranged in the first slope portion SP1 may travel along a first light path LP1, and, thus, light in one direction may be concentrated. Therefore, non-uniform luminance may occur according to the direction.

In the present embodiment, since the second slope portion SP2 having a slope in a direction opposite to that of the first slope portion SP1 is arranged in the emission area EA, light may travel along a second light path LP2 having a direction different from that of the first light path LP1, and thus compensate for non-uniformity in luminance.

In an embodiment, the first slope portion SP1 has a gentler slope than that of the second slope portion SP2. Therefore, in order to obtain uniform or substantially uniform luminance according to a direction, an area in which the emission area EA overlaps the first slope portion SP1 may be larger than an area in which the emission area EA overlaps the second slope portion SP2. That is, an area occupied in the emission area EA by the first slope portion SP1 may be larger than an area occupied in the emission area EA by the second slope portion SP2.

Since the size of the emission area EA may be different for each pixel, the size occupied in the emission area EA by the first slope portion SP1 may be different from the size occupied in the emission area EA by the second slope portion SP2. Therefore, the spacing distance (d) between the opening OP and the via hole VH may be different in each of the pixels.

In one embodiment, the emission areas EA of the red pixel and the blue pixel may be larger than the emission area EA of the green pixel. In this case, in an embodiment, in the red pixel and the blue pixel, the spacing distance d(R, B) may satisfy 0 ≤ d(R, B) ≤ 1.2 µm. In an embodiment, in the green pixel, the spacing distance d(G) may satisfy 0 ≤ d(G) ≤ 2.8 µm.

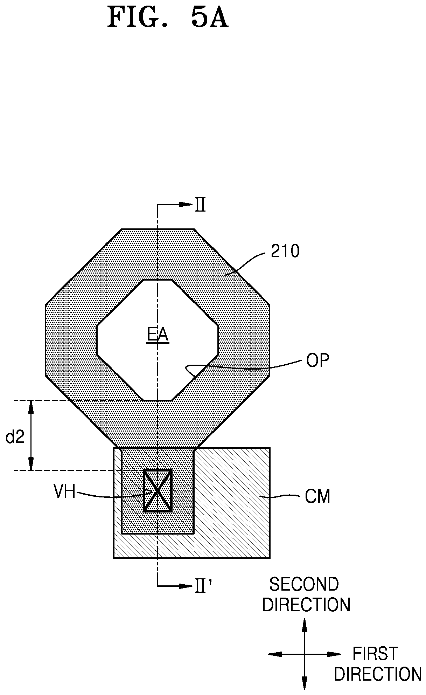

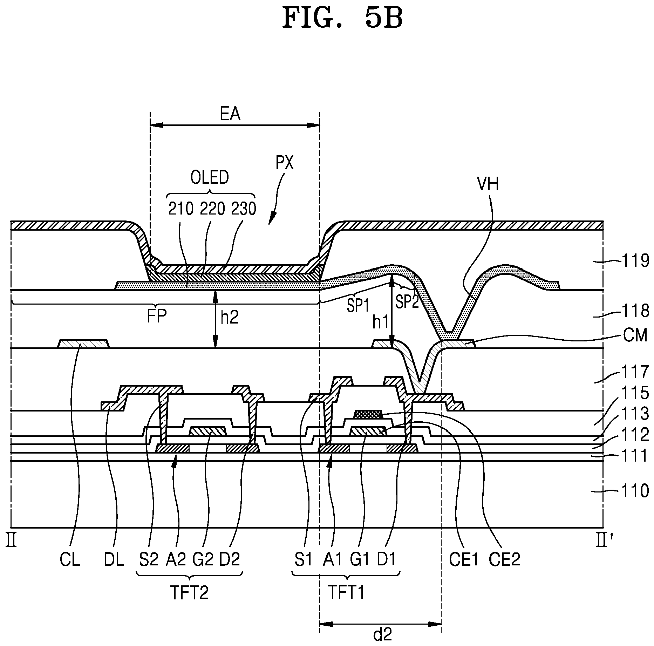

FIG. 5A is a schematic layout diagram illustrating a relationship between an emission area EA, a pixel electrode 210, and a via hole VH arranged at a side of the pixel electrode 210 in a pixel PX, according to an embodiment; and FIG. 5B is a schematic cross-sectional view taken along the line II-II' of FIG. 5A. In FIGS. 5A and 5B, the same reference numerals as those in FIGS. 4A and 4B refer to the same or like elements, and a redundant description thereof may be omitted.

Referring to FIGS. 5A and 5B, the pixel electrode 210 included in a pixel PX may include an emission area EA, through which light is emitted, and an area overlapping the via hole VH. The emission area EA may be defined by an opening OP of a pixel defining layer 119 that exposes a central portion of the pixel electrode 210. The via hole VH may be defined in a second insulating layer 118 so as to connect the pixel electrode 210 to a connection electrode CM. When the pixel electrode 210 is inserted into the via hole VH, the pixel electrode 210 may be connected to the connection electrode CM.

In this case, the pixels PX according to the present embodiment may be designed such that a spacing distance (d) between the opening OP and the via hole VH satisfies a certain range. The spacing distance (d) may be the shortest distance (d) between an end of the opening OP and an end of the via hole VH. Alternatively, the spacing distance (d) may be a spacing distance between the end of the opening OP and the end of the via hole VH in a second direction.

In the present embodiment, the second insulating layer 118, on which the pixel electrode 210 is arranged, may include a flat portion FP, a first slope portion SP1 having a relatively gentle slope, and a second slope portion SP2 having a relatively steep slope.

In one embodiment, the spacing distance (d) may satisfy d ≥ d2 and d2 > 5 µm. In this case, (d) may have different values for each of the red, green, and blue pixels. These numerical values may be introduced so as to make the viewing angle uniform or substantially uniform in the vertical direction.

Referring to FIG. 5B, in the present embodiment, the emission area EA may be arranged to overlap the flat portion FP of the second insulating layer 118. That is, the second slope portion SP2 may not be arranged in the emission area EA. In an embodiment, the first slope portion SP1 and the second slope portion SP2 may not be arranged in the emission area EA. That is, since the opening OP is apart from the via hole VH by a certain distance or more, the upper surface of the second insulating layer 118 arranged in the emission area EA may be parallel to the upper surface of the substrate 110.

The first slope portion SP1 and the second slope portion SP2 may be provided in an area adjacent to the via hole VH. The upper surface of the second insulating layer 118 may be provided to be flat with respect to an area apart from the via hole VH by a certain distance or more.

When the upper surface of the second insulating layer 118 is parallel to the upper surface of the substrate 110 in the emission area EA, the viewing angle may be uniform or substantially uniform in the vertical and horizontal directions.

Since the size of the emission area EA may be different for each pixel, the spacing distance (d) between the opening OP and the via hole VH may be different in each of the pixels.

In one embodiment, the emission areas EA of the red pixel and the blue pixel may be larger than the emission area EA of the green pixel. In this case, in an embodiment, in the red pixel and the blue pixel, the spacing distance d(R, B) may satisfy d(R, B) ≥ 5 µm. In an embodiment, in the green pixel, the spacing distance d(G) may satisfy d(G) ≥ 6 µm.

In summary, referring to FIGS. 4A to 5B, the spacing distance (d) between the opening OP, which defines the emission area EA of the pixel, and the via hole VH may satisfy 0 ≤ d ≤ d1 or d ≥ d2 and d1 and d2 may be differently set according to the pixel.

In one or more embodiments, the spacing distance d(R, B) in the red pixel and the blue pixel may satisfy 0 ≤ d(R, B) ≤ 1.2 µm or d(R, B) ≥ 5 µm.

In one or more embodiments, the spacing distance d(G) in the green pixel may satisfy 0 ≤ d(G) ≤ 2.8 µm or d(G) ≥ 5 µm.

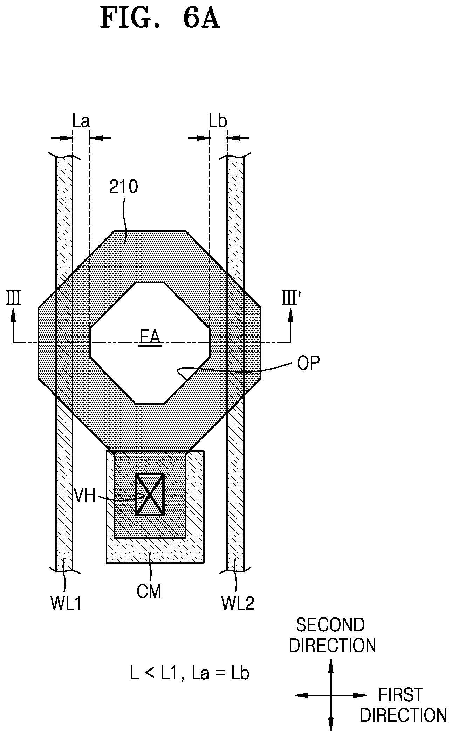

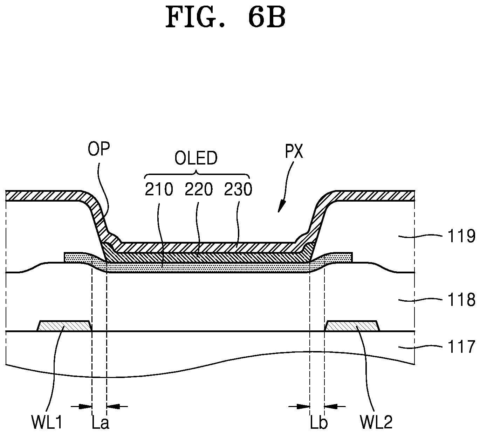

FIG. 6A is a schematic layout diagram illustrating a relationship between an emission area EA, a pixel electrode 210, and a wiring arranged below the pixel electrode 210 in a pixel PX, according to an embodiment; and FIG. 6B is a schematic cross-sectional view taken along the line III-III' of FIG. 6A. In FIGS. 6A and 6B, the same reference numerals as those in FIGS. 4A and 4B refer to the same or like elements, and a redundant description thereof may be omitted.

Referring to FIGS. 6A and 6B, the pixel electrode 210 included in the pixel PX may include an emission area EA, through which light is emitted, and an area overlapping a via hole VH. The emission area EA may be defined by an opening OP of a pixel defining layer 119 that exposes a central portion of the pixel electrode 210. The via hole VH may be defined in a second insulating layer 118 so as to connect the pixel electrode 210 to a connection electrode CM. When the pixel electrode 210 is inserted into the via hole VH, the pixel electrode 210 may be connected to the connection electrode CM.

In the present embodiment, a first wiring WL1 and a second wiring WL2 arranged in a first direction may be arranged below the pixel electrode 210. The first wiring WL1 and the second wiring WL2 may be arranged above the second insulating layer 118. The first wiring WL1 and the second wiring WL2 may be arranged on a same layer as that of the connection electrode CM.

The second insulating layer 118 may be provided to cover the first wiring WL1 and the second wiring WL2, and the upper surface of the second insulating layer 118 may be bent, or sloped, according to the shapes of the first wiring WL1 and the second wiring WL2.

Therefore, when the first wiring WL1 and the second wiring WL2 are arranged to be close to the emission area EA, a shape of the upper surface of the second insulating layer 118 arranged in the emission area EA may be affected to cause a luminance difference according to the left and right (first direction) viewing angle.

As such, when a first spacing distance La between the first wiring WL1 and an end of the opening OP of the pixel defining layer 119 is less than a certain distance L1 to affect a viewing angle, the second wiring WL2 may be designed to be symmetrically arranged with respect to the center point of the emission area EA. That is, a second spacing distance Lb between the second wiring WL2 and an end of the opening OP of the pixel defining layer 119 may be provided in the same manner as the first spacing distance La, and, in an embodiment, the first and second spacing distances La and Lb may be the same and correspond to a distance L.

In an embodiment, the pixel that is most affected by the first wiring WL1 and the second wiring WL2 may be the green pixel having the smallest size. In an embodiment, in the case of the green pixel, L1 may be 1.2 µm. That is, in an embodiment, in the case of the green pixel, when the first wiring WL1 is arranged within 1.2 µm from the emission area EA, the second wiring WL2 may be designed to be arranged symmetrically with the first wiring WL1 with respect to the emission area EA.

In an embodiment, the first wiring WL1 and the second wiring WL2 may be data lines or driving voltage lines. In another embodiment, the first wiring WL1 may be a data line, and the second wiring WL2 may be a driving voltage line.

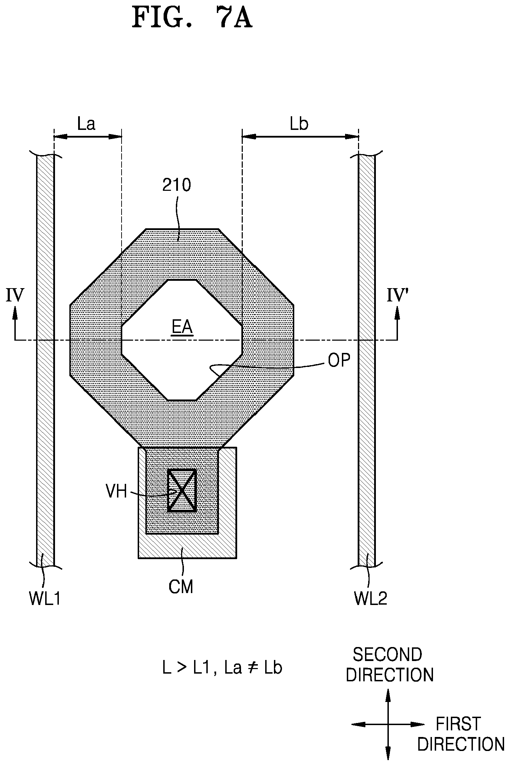

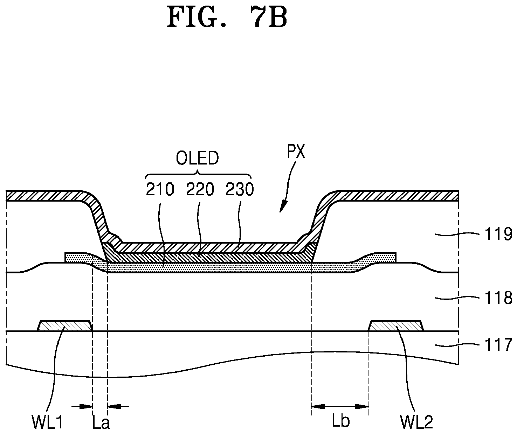

FIG. 7A is a schematic layout diagram illustrating a relationship between an emission area EA, a pixel electrode 210, and a wiring arranged below the pixel electrode 210 in a pixel PX, according to an embodiment; and FIG. 7B is a schematic cross-sectional view taken along the line IV-IV' of FIG. 7A. In FIGS. 7A and 7B, the same reference numerals as those in FIGS. 4A and 4B refer to the same or like elements, and a redundant description thereof may be omitted.

Referring to FIGS. 7A and 7B, the pixel electrode 210 included in the pixel PX may include the emission area EA, through which light is emitted, and an area overlapping a via hole VH. The emission area EA may be defined by an opening OP of a pixel defining layer 119 that exposes a central portion of the pixel electrode 210. The via hole VH may be defined in a second insulating layer 118 so as to connect the pixel electrode 210 to a connection electrode CM. When the pixel electrode 210 is inserted into the via hole VH, the pixel electrode 210 may be connected to the connection electrode CM.

In the present embodiment, a first wiring WL1 and a second wiring WL2 arranged in a first direction may be arranged below the pixel electrode 210. The first wiring WL1 and the second wiring WL2 may be arranged above the second insulating layer 118. The first wiring WL1 and the second wiring WL2 may be arranged on a same layer as that of the connection electrode CM.

When the first wiring WL1 is apart from the emission area EA by L1 or more, the first wiring WL1 may not affect the emission area EA. In this case, the first wiring WL1 and the second wiring WL2 may not be symmetrically arranged with respect to the emission area EA. That is, when La, Lb > L1, La ≠ Lb. In one or more embodiments, L1 may be 1.2 µm.

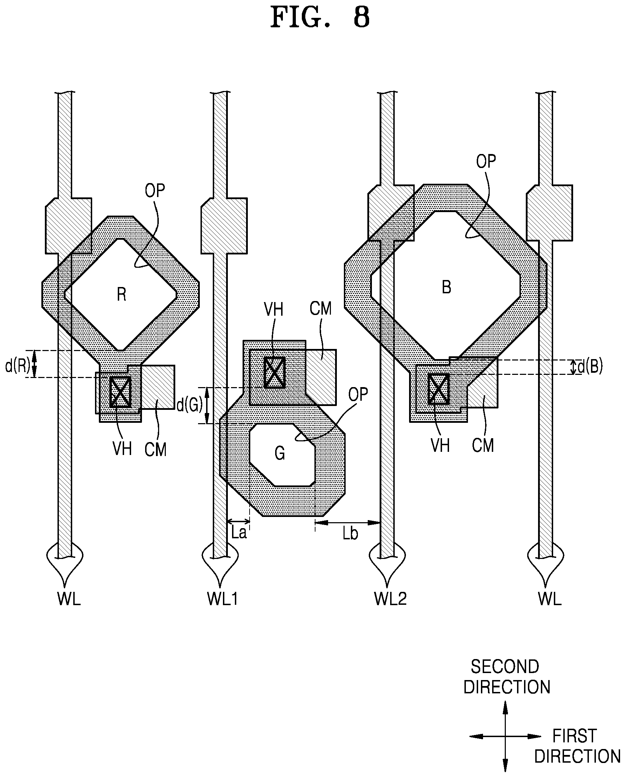

FIG. 8 is a schematic layout diagram illustrating a relationship between emission areas, pixel electrodes, and wirings arranged below the pixel electrodes in a plurality of pixels, according to an embodiment.

Referring to FIG. 8, the pixels may include a red pixel R, a green pixel G, and a blue pixel B. In an embodiment, a spacing distance d(R) between the red pixel R and the emission area, a spacing distance d(G) between the green pixel G and the emission area, and a spacing distance d(B) between the blue pixel B and the emission area may be different from each other.

In an embodiment, the emission areas EA of the red pixel R, the green pixel G, and the blue pixel B may be arranged according to a pentile matrix structure. The spacing distances d(R), d(G), and d(B) may be set differently by adjusting the position of the via hole VH included in each pixel.

Therefore, the center point of the via hole VH of the red pixel R, the center point of the via hole VH of the green pixel G, and the center point of the via hole VH of the blue pixel B may not be arranged on a straight line in the first direction, but may be arranged in a zigzag arrangement.

In one or more embodiments, d(R) > d(B) ≥ 5 µm and d(G) > 6 µm.

In an embodiment, the green pixel G is sensitive to the left and right viewing angles, and the first wiring WL1 and the second wiring WL2 arranged on both sides of the green pixel G may be apart from the emission area EA of the green pixel G by 1.2 µm or more. Therefore, the spacing distance between the first wiring WL1 and the emission area of the green pixel G and the spacing distance between the second wiring WL2 and the emission area of the green pixel G may be different from each other.

In an embodiment, the red pixel R and the blue pixel B are not sensitive to the left and right viewing angles, and the emission area EA and the wiring WL may partially overlap each other.

In the present embodiment, the spacing distance between the emission area EA and the via hole VH may be differently provided according to the red pixel R, the green pixel G, and the blue pixel B, thereby minimizing or reducing a difference between upper and lower white angle differences (WADs) of the organic light-emitting display apparatus.

According to various embodiments, it is possible to minimize or reduce a side color shift phenomenon of an organic light-emitting display apparatus while maintaining uniform characteristics between the pixels and to ensure uniformity in the horizontal and vertical WADs.

It is to be understood that embodiments described herein should be considered in a descriptive sense and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein.

## Claims

1. An organic light-emitting display apparatus comprising
a red pixel (R), a green pixel (G), and a blue pixel (B), each comprising:
a first insulating layer (117) on a substrate (110);
a connection electrode (CM) on the first insulating layer (117);
a second insulating layer (118) on the first insulating layer (117) to cover the connection electrode (CM);
an organic light-emitting diode (OLED) on the second insulating layer (118), the organic light-emitting diode (OLED) comprising a pixel electrode (210), an intermediate layer comprising an organic emission layer, and an opposite electrode (230);
a pixel defining layer (119) covering an edge of the pixel electrode (210) and comprising an opening (OP) exposing a central portion of the pixel electrode (210), the opening (OP) defining an emission area (EA); and
a via hole (VH) defined in the second insulating layer (118) and through which the pixel electrode (210) is connected to the connection electrode (CM),
wherein a spacing distance (d) between the emission area (EA) and the via hole (VH) is different in each of the red pixel (R), the green pixel (G), and the blue pixel (B).

2. The organic light-emitting display apparatus of claim 1, wherein
in the red pixel (R), 0 ≤ d(R) ≤ 1.2 µm or d(R) ≥ 5 µm, where d(R) is the spacing distance (d) between the emission area (EA) and the via hole (VH) in the red pixel (R), and
in the blue pixel (B), 0 ≤ d(B) ≤ 1.2 µm or d(B) ≥ 5 µm, where d(B) is the spacing distance (d) between the emission area (EA) and the via hole (VH) in the blue pixel (B).

3. The organic light-emitting display apparatus of at least one of claims 1 or 2, wherein, in the green pixel (G), 0 ≤ d(G) ≤ 2.8 µm or d(G) ≥ 5 µm, where d(G) is the spacing distance (d) between the emission area (EA) and the via hole (VH) in the green pixel (G).

4. The organic light-emitting display apparatus of at least one of claims 1 to 3, wherein, in at least one of the red pixel (R), the green pixel (G), and the blue pixel (B), an upper surface of the second insulating layer (118) in the emission area (EA) has a first slope portion (SP1) and a second slope portion (SP2) which are sloped in different directions from each other.

5. The organic light-emitting display apparatus of at least one of claims 1 to 4, wherein, in at least one of the red pixel (R), the green pixel (G), and the blue pixel (B), an upper surface of the second insulating layer (118) in the emission area (EA) is parallel to an upper surface of the substrate (110).

6. The organic light-emitting display apparatus of at least one of claims 1 to 5, further comprising a first wiring (WL1) on a same layer as the connection electrode (CM) and located adjacent to the emission area (EA) of the green pixel (G),
wherein a spacing distance (d) between the emission area (EA) of the green pixel (G) and the first wiring (WL1) is greater than or equal to 1.2 µm.

7. The organic light-emitting display apparatus of at least one of claims 1 to 6, further comprising a first wiring (WL1) and a second wiring (WL2), which are on a same layer as the connection electrode (CM) with the emission area (EA) therebetween,
wherein a spacing distance (d) between the first wiring (WL1) and the emission area (EA) is equal to a spacing distance (d) between the second wiring (WL2) and the emission area (EA).

8. The organic light-emitting display apparatus of claim 7, wherein the spacing distance (d) between the first wiring (WL1) and the emission area (EA) is less than or equal to 1.2 µm.

9. The organic light-emitting display apparatus of at least one of claims 1 to 8, further comprising a first wiring (WL1) and a second wiring (WL2), which are on a same layer as the connection electrode (CM) with the emission area (EA) therebetween, wherein a spacing distance (d) between the first wiring (WL1) and the emission area (EA) is different from a spacing distance (d) between the second wiring (WL2) and the emission area (EA), and
the spacing distance (d) between the first wiring (WL1) and the emission area (EA) is greater than the spacing distance (d) between the second wiring (WL2) and the emission area (EA) by 1.2 µm or more.

10. The organic light-emitting display apparatus of at least one of claims 1 to 9, wherein the red pixel (R), the green pixel (G), and the blue pixel (B) are arranged in a pentile matrix structure, and
an emission area (EA) of the green pixel (G) is smaller than emission areas (EA) of the red pixel (R) and the blue pixel (B).

11. An organic light-emitting display apparatus comprising:
a first insulating layer (117) on a substrate (110);
a connection electrode (CM) on the first insulating layer (117);
a second insulating layer (118) on the first insulating layer (117) to cover the connection electrode (CM);
an organic light-emitting diode (OLED) on the second insulating layer (118), the organic light-emitting diode (OLED) comprising a pixel electrode (210), an intermediate layer comprising an organic emission layer, and an opposite electrode (230);
a pixel defining layer (119) covering an edge of the pixel electrode (210) and comprising an opening (OP) exposing a central portion of the pixel electrode (210), the opening (OP) defining an emission area (EA); and
a via hole (VH) defined in the second insulating layer (118) and through which the pixel electrode (210) is connected to the connection electrode (CM),
wherein an upper surface of the second insulating layer (118) comprises a flat portion (FP) parallel to an upper surface of the substrate (110), a first slope portion (SP1) having a first slope angle with respect to the upper surface of the substrate (110), and a second slope portion (SP2) having a second slope angle with respect to the upper surface of the substrate (110), the second slope angle greater than the first slope angle, and the second slope portion (SP2) is located closer to the via hole (VH) than the first slope portion (SP1).

12. The organic light-emitting display apparatus of claim 11, wherein the emission area (EA) overlaps with the first slope portion (SP1) and the second slope portion (SP2).

13. The organic light-emitting display apparatus of at least one of claims 11 or 12, wherein an area in which the first slope portion (SP1) overlaps with the emission area (EA) is larger than an area in which the second slope portion (SP2) overlaps with the emission area (EA).

14. The organic light-emitting display apparatus of at least one of claims 11 to 13, wherein the emission area (EA) overlaps with the flat portion (FP) and does not overlap with the second slope portion (SP2).

15. The organic light-emitting display apparatus of at least one of claims 11 to 13, further comprising a first wiring (WL1) and a second wiring (WL2), which are on a same layer as the connection electrode (CM) with the emission area (EA) therebetween, wherein a spacing distance (d) between the first wiring (WL1) and the emission area (EA) is equal to a spacing distance (d) between the second wiring (WL2) and the emission area (EA).

16. The organic light-emitting display apparatus of claim 15, wherein the spacing distance (d) between the first wiring (WL1) and the emission area (EA) is less than or equal to 1.2 µm.

17. The organic light-emitting display apparatus of at least one of claims 15 or 16, wherein the first insulating layer (117) is bent according to shapes of the first wiring (WL1) and the second wiring (WL2).

18. The organic light-emitting display apparatus of claim 11, further comprising a first wiring (WL1) and a second wiring (WL2), which are on a same layer as the connection electrode (CM) with the emission area (EA) therebetween, wherein a spacing distance (d) between the first wiring (WL1) and the emission area (EA) is different from a spacing distance (d) between the second wiring (WL2) and the emission area (EA), and
the spacing distance (d) between the first wiring (WL1) and the emission area (EA) is greater than the spacing distance (d) between the second wiring (WL2) and the emission area (EA) by 1.2 µm or more.

19. The organic light-emitting display apparatus of claim 11, comprising a red pixel (R), a green pixel (G), and a blue pixel (B), and
a spacing distance (d) between the emission area (EA) and the via hole (VH) is different in each of the red pixel (R), the green pixel (G), and the blue pixel (B).

20. The organic light-emitting display apparatus of claim 19, wherein the red pixel (R), the green pixel (G), and the blue pixel (B) are arranged in a pentile matrix structure, and
an emission area (EA) of the green pixel (G) is smaller than emission areas (EA) of the red pixel (R) and the blue pixel (B).
